# EUROPÄISCHE PATENTSCHRIFT

(11) **EP 2 315 355 B1**
(45) Veröffentlichungstag und Bekanntmachung des Hinweises auf die Patenterteilung: **25.01.2017**
(21) Anmeldenummer: 10187840.3
(22) Anmeldetag: 18.10.2010
(51) Int. Cl.: H03K 21/02

(54) **Verfahren und Vorrichtung zum Betreiben einer Pulserkennungsvorrichtung**
Method and device for operating a pulse detection device
Procédé et dispositif destinés au fonctionnement d'un dispositif de reconnaissance d'impulsion

(30) Priorität: 23.10.2009 DE 102009050508
(43) Veröffentlichungstag der Anmeldung: 27.04.2011
(73) Patentinhaber: Continental Automotive GmbH, 30165 Hannover (DE)
(72) Erfinder: Semmelrodt, Sven Dr., 78662, Bösingen (DE)

(56) Entgegenhaltungen:
- WO-A1-99/42789
- DE-A1- 19 732 960

## Beschreibung

Die Erfindung betrifft ein Verfahren und eine Vorrichtung zum Betreiben einer Pulserkennungsvorrichtung mit einer Entscheidervorrichtung, die ausgebildet ist, digitale Signalwerte eingangsseitig zu empfangen, welche ein digital gewandeltes Pulssignal eines analogen Pulssignals repräsentieren.

Pulserkennungsvorrichtungen werden beispielsweise in elektronischen Steuerungssystemen für Kraftfahrzeuge wie Antiblockiersysteme, Fahrdynamikregelungssysteme und elektrischen Lenkhilfen eingesetzt. Diese Systeme sind jeweils mit einem oder mehreren Sensoren ausgestattet. Die Sensoren geben in Abhängigkeit ihrer Anregung analoge Signale aus. Erfolgt die Anregung der Sensoren periodisch, beispielsweise durch ein rotierendes Pulsgeberrad, weist das vom Sensor ausgegebene Signal eine Periodizität auf, die abhängig ist von der Rotationsgeschwindigkeit des Pulsgeberrades.

In der DE 102007005890 B3 ist ein Verfahren offenbart zur Erkennung von Impulsen und insbesondere von Impulsen, die durch ein Impulsgeberrad und einen Sensor erzeugt werden zum Ermitteln einer Drehzahl insbesondere in einem Getriebe eines Fahrzeugs.

WO 99/42789 offenbart eine Vorrichtung zum Erkennen einer relativen Bewegung zwischen einem Punkt auf einem Körper und einer Referenzposition, die Folgendes umfasst:
- ein Paar Magnetfeldsensoren, die lateral in Richtung einer relativen Bewegung zwischen dem Körper und der Referenzposition angeordnet sind;
- einen Magnet, der an der Referenzposition angeordnet ist, um ein Magnetfeld durch den Körper und das Paar Magnetfeldsensoren zu erzeugen, wobei die Größe des durch den Körper und das Sensorpaar passierenden Feldes auf die relative Position zwischen dem Punkt auf dem Körper und der Referenzposition bezogen ist, wobei jeder der Sensoren ein Ausgangssignal in Bezug auf die Größe des einen solchen Sensor passierenden Magnetfeldes erzeugt;
- eine Differenzschaltung, die mit dem Ausgangssignal gespeist wird, das von jedem der Sensoren erzeugt wird, um ein Differenzsignal zu erzeugen, das einen Spitzenwert hat, wenn sich der Punkt auf dem Körper zwischen dem Sensorpaar befindet;
- einen Spitzenwertdetektor zum Erkennen des Spitzenwertes in dem Differenzsignal;
- eine mit dem Differenzsignal gespeiste Schwellenwertschaltung;
- eine Schwellenwertjustierschaltung zum Einstellen des Schwellenwertes gemäß der Größe des Differenzsignals und
- eine Ausgabeschaltung zum Erzeugen eines Ausgangssignals, die auf den Betrieb der Schwellenwertschaltung anspricht.

DE 197 32 960 A1 offenbart eine Einrichtung zur Auswertung einer Wechselspannung bzw. eines Wechselstromes, bei der die Wechselspannung bzw. der Wechselstrom mit Hilfe eines Fensterkomparators mit variablen Schwellen ausgewertet wird. Über ein VCL-Signal, das jeweils umschaltet, wenn eine Schwellenanpassung erfolgt, lässt sich ein frequenzabhängiges Signal erzeugen, das als Maß für die Drehzahl auswertbar ist.

Die Aufgabe, die der Erfindung zugrunde liegt, ist es, ein Verfahren und eine Vorrichtung zu schaffen, das beziehungsweise die ein zuverlässiges Betreiben einer Pulserkennungsvorrichtung ermöglicht.

Die Aufgabe wird gelöst durch die Merkmale der unabhängigen Patentansprüche, vorteilhafte Ausgestaltungen sind in den Unteransprüchen gekennzeichnet.

Die Erfindung zeichnet sich aus durch ein Verfahren und eine entsprechende Vorrichtung zum Betreiben einer Pulserkennungsvorrichtung. Die Pulserkennungsvorrichtung umfasst eine Entscheidervorrichtung mit einem Eingang und einem Ausgang, die ausgebildet ist, digitale Signalwerte, welche ein digital gewandeltes Pulssignal eines analogen Pulssignals repräsentieren, eingangsseitig zu empfangen. Zusätzlich ist die Entscheidervorrichtung ausgebildet einen ersten Ausgangssignalwert ausgangsseitig auszugeben, wenn der am Eingang anliegende digitale Signalwert größer ist als ein vorgegebener erster Schwellenwert und einen zweiten Ausgangssignalwert ausgangsseitig auszugeben, wenn der am Eingang anliegende digitale Signalwert kleiner ist als ein vorgegebener zweiter Schwellenwert, wobei der zweite Schwellenwert kleiner ist als der erste Schwellenwert. Jeweils für eine vorgegebene Segmentzeitdauer wird aus den eingangsseitig empfangenen digitalen Signalwerten eine erste Wertemenge mit einer vorgegebenen ersten Anzahl der größten Signalwerte ermittelt und eine zweite Wertemenge mit einer vorgegebenen zweiten Anzahl der kleinsten digitalen Signalwerte ermittelt. Der erste Schwellenwert wird angepasst abhängig von der ersten Wertemenge und/oder der zweite Schwellenwert wird angepasst abhängig von der zweiten Wertemenge. Der erste Schwellenwert und der zweite Schwellenwert wird ermittelt abhängig von einem Entscheiderschwellwert und einem vorgegebenen Hysteresewert, wobei der Entscheiderschwellwert ermittelt wird abhängig von den digitalen Signalwerten der ersten Wertemenge und der zweiten Wertemenge. Der Hysteresewert wird angepasst in Abhängigkeit von einer für das analoge Pulssignal ermittelten Frequenz.

So wird ein Beitrag geleistet, beliebige Amplituden und Gleichanteilsänderungen des analogen Pulssignals beim Anpassen des ersten und/oder des zweiten Schwellenwertes zu berücksichtigen und so einen zuverlässigen Betrieb der Pulserkennungsvorrichtung zu ermöglichen. Auf diese Weise können beispielsweise Störeinflüsse durch hohe Temperaturschwankungen, Verschmutzung, starke Vibration, starke elektromagnetische Störung sowie große mechanische Toleranzen in Folge von Verschleiß einfach und wirkungsvoll kompensiert werden. Das Ermitteln der digitalen Signalwerte der ersten und zweiten Wertemenge kann beispielsweise mittels einfacher Vergleichsoperationen durchgeführt werden. Das Ermittteln des ersten Schwellenwerts und des zweiten Schwellenwerts abhängig von dem Entscheiderschwellwert und der Hysterese hat den Vorteil, dass der erste und zweite Schwellenwert einfach angepasst werden können. Der Hysteresewert kann fest vorgegeben sein oder kann auch während des Betriebes anpassbar sein. Die Anpassung des Hysteresewerts in Abhängigkeit von der für das analoge Pulssignal ermittelten Frequenz hat den Vorteil, dass der Einfluss verschiedener Störeinflüsse besonders wirksam gering gehalten werden kann.

Gemäß einer weiteren vorteilhaften Ausgestaltung der Erfindung wird aus den digitalen Signalwerten der ersten Wertemenge ein arithmetischer Maximalmittelwert und aus den digitalen Signalwerten der zweiten Wertemenge ein arithmetischer Minimalmittelwert gebildet und der erste Schwellenwert und/oder der zweite Schwellenwert abhängig von dem Maximalmittelwert und dem Minimalmittelwert angepasst. Das Anpassen des ersten und/oder zweiten Schwellenwertes abhängig von dem arithmetischen Maximalmittelwert und arithmetischen Minimalmittelwert hat im Vergleich dazu, wenn beispielsweise ein arithmetischer Mittelwert über alle digitale Signalwerte innerhalb der Segmentzeitdauer ermittelt wird, den Vorteil, dass unsymmetrische analoge Pulssignale zuverlässiger erkannt werden.

Gemäß einer weiteren vorteilhaften Ausgestaltung der Erfindung entspricht die erste Anzahl und die zweite Anzahl einer Zweierpotenz. Dies hat den Vorteil, dass beispielsweise für die Berechnung des arithmetischen Maximalmittelwertes und des arithmetischen Minimalmittelwertes erforderliche Divisionen durch einfache Schiebeoperationen ersetzt werden können.

Gemäß einer weiteren vorteilhaften Ausgestaltung der Erfindung sind die erste Anzahl und die zweite Anzahl gleich groß. Dadurch können mehrere Rechenschritte zusammengefasst und vereinfacht werden.

Gemäß einer weiteren vorteilhaften Ausgestaltung der Erfindung werden jeweils über die Segmentzeitdauer eine erste Kandidatenanzahl von größten digitalen Signalwerten und eine zweite Kandidatenanzahl von kleinsten digitalen Signalwerten ermittelt. Eine erste Verwerfanzahl der größten digitalen Signalwerte werden verworfen und die verbleibenden größten digitalen Signalwerte werden der ersten Wertenmenge zugeordnet und eine zweite Verwerfanzahl der kleinsten digitalen Signalwerte werden verworfen und die verbleibenden kleinsten digitalen Signalwerte werden der zweiten Wertemenge zugeordnet. Die erste Kandidatenanzahl ist um die erste Verwerfanzahl größer als die erste Anzahl und die zweite Kandidatenanzahl ist um die zweite Verwerfanzahl größer als die zweite Anzahl. Dies hat den Vorteil, dass digitale Signalwerte, die stark verrauscht und/oder fehlerbehaftet sind, mit geringem Rechenaufwand ermittelt werden können und nicht für das Ermitteln des ersten und/oder zweiten Schwellenwertes herangezogen werden.

Gemäß einer weiteren vorteilhaften Ausgestaltung der Erfindung werden die erste Wertemenge und die zweite Wertemenge erneut ermittelt, jeweils für aufeinander folgende überlappende Segmentzeitdauern. Dies hat den Vorteil, dass der erste und/oder zweite Schwellenwert in kürzeren Zeitabständen angepasst werden und Gleichanteilsänderungen und Amplitudenänderungen des analogen Pulssignals schneller berücksichtig werden bei der Anpassung des ersten und/oder zweiten Schwellenwertes.

Gemäß einer weiteren vorteilhaften Ausgestaltung der Erfindung wird eine Amplitudendynamik ermittelt abhängig von der Differenz des Maximalmittelwertes und des Minimalmittelwertes und das Anpassen des ersten Schwellenwertes und/oder des zweiten Schwellenwertes ausgesetzt, wenn die Amplitudendynamik einen vorgegebenen unteren Grenzwert unterschreitet. Eine Anpassung des ersten und des zweiten Schwellenwertes unter Berücksichtigung der Amplitudendynamik verhindert, dass einem analogen Pulssignal mit sehr niedriger Frequenz fälschlicherweise ein Gleichanteil zugeordnet wird und der erste und/oder zweite Schwellenwert entsprechend dieses Gleichanteils angepasst wird. Der Gleichanteil entsteht, wenn die erste und zweite Wertemenge, die über die Segmentzeitdauer ermittelt werden, jeweils sehr ähnliche digitale Signalwerte repräsentieren.

Gemäß einer weiteren vorteilhaften Ausgestaltung der Erfindung wird ein Fehlersignal ausgegeben, wenn über eine vorgegebene Beobachtungszeitdauer eine vorgegebene Fehleranzahl von digitalen Signalwerten einen für das analoge Pulssignal charakteristischen minimalen Amplitudenwert unterschreiten oder einen für das analoge Pulssignal charakteristischen maximalen Amplitudenwert überschreiten. Dies hat den Vorteil, dass Störungen, die beispielsweise durch Manipulation des analogen Pulssignals und/oder durch eine Übersteuerung eines Analog-Digital-Wandlers entstehen, erkannt werden können und ein Fehlverhalten der Pulserkennungseinrichtung vermieden wird.

Gemäß einer weiteren vorteilhaften Ausgestaltung repräsentiert das analoge Pulssignal ein Messsignal eines Sensors.

Gemäß einer weiteren vorteilhaften Ausgestaltung der Erfindung ist der Sensor ein Hallsensor. Hallsensoren arbeiten berührungslos. Zwischen einem Sendeelement, zum Beispiel einem Permanentmagnet, und einem Empfangselement, zum Beispiel einem Hallelement, des Sensors besteht keine mechanische Verbindung. Dadurch ist es einfach möglich, mit Hallsensoren Drehbewegungen von rotierenden Elementen zu erfassen. Zusätzlich sind Hallsensoren im Vergleich zu optischen oder mechanischen Sensoren weniger anfällig gegenüber Störungen aufgrund extremer Temperaturschwankungen, starker Vibrationen, instabilen Spannungsvorsorgungen und mechanischen Toleranzen aufgrund von Verschleiß.

Ausführungsbeispiele von Ausgestaltungen der Erfindung sind im Folgenden anhand der schematischen Zeichnungen näher erläutert.

Es zeigen:
Figur 1 eine Vorrichtung zum Betreiben einer Pulserkennungsvorrichtung 1 mit einer Pulserkennungsvorrichtung 1,
Figur 2 ein Ablaufdiagramm eines Programms zum Betreiben einer Pulserkennungsvorrichtung 1,
Figur 3 einen Verlauf eines beispielhaften analogen Pulssignal A und einen diesem analogen Pulssignal A zugeordneten beispielhaften Verlauf der digitalen Signalwerte S,
Figur 4 einen normierten Verlauf einer maximalen Abweichung S_delta der digitalen Signalwerten S von einem Scheitelwert S_top,
Figur 5A-5C Diagramme mit einem ersten zeitlichen Verlauf eines analogen Pulsignals A, einem ersten zeitlichen Verlauf der digitalen Signalwerte S und des ersten H_th und zweiten Schwellenwertes L_th und einer erste Folge P des ersten P1 und zweiten Ausgangssignalwertes P0,
Figur 6A-6C Diagramme mit einem zweiten zeitlichen Verlauf eines analogen Pulsignals A, einem zweiten zeitlichen Verlauf der digitalen Signalwerte S und des ersten H_th und zweiten Schwellenwertes L_th und einer zweite Folge P des ersten P1 und zweiten Ausgangssignalwertes P0,
Figur 7A-7C Diagramme mit einem dritten zeitlichen Verlauf eines analogen Pulsignals A, einem dritten zeitlichen Verlauf der digitalen Signalwerte S und des ersten H_th und zweiten Schwellenwertes L_th und einer dritten Folge P des ersten P1 und zweiten Ausgangssignalwertes P0,
Figur 8A-8C Diagramme mit einem vierten zeitlichen Verlauf eines analogen Pulsignals A, einem vierten zeitlichen Verlauf der digitalen Signalwerte S und des ersten H_th und zweiten Schwellenwertes L_th und einer vierten Folge P des ersten P1 und zweiten Ausgangssignalwertes P0,
Figur 9A-9C Diagramme mit einem fünften zeitlichen Verlauf eines analogen Pulsignals A, einem fünften zeitlichen Verlauf der digitalen Signalwerte S und des ersten H_th und zweiten Schwellenwertes L_th und einer fünften Folge P des ersten P1 und zweiten Ausgangssignalwertes P0 und
Figur 10A-10C Diagramme mit einem sechsten zeitlichen Verlauf eines analogen Pulsignals A, einem sechsten zeitlichen Verlauf der digitalen Signalwerte S und des ersten H_th und zweiten Schwellenwertes L_th und einer sechsten Folge P des ersten P1 und zweiten Ausgangssignalwertes P0.

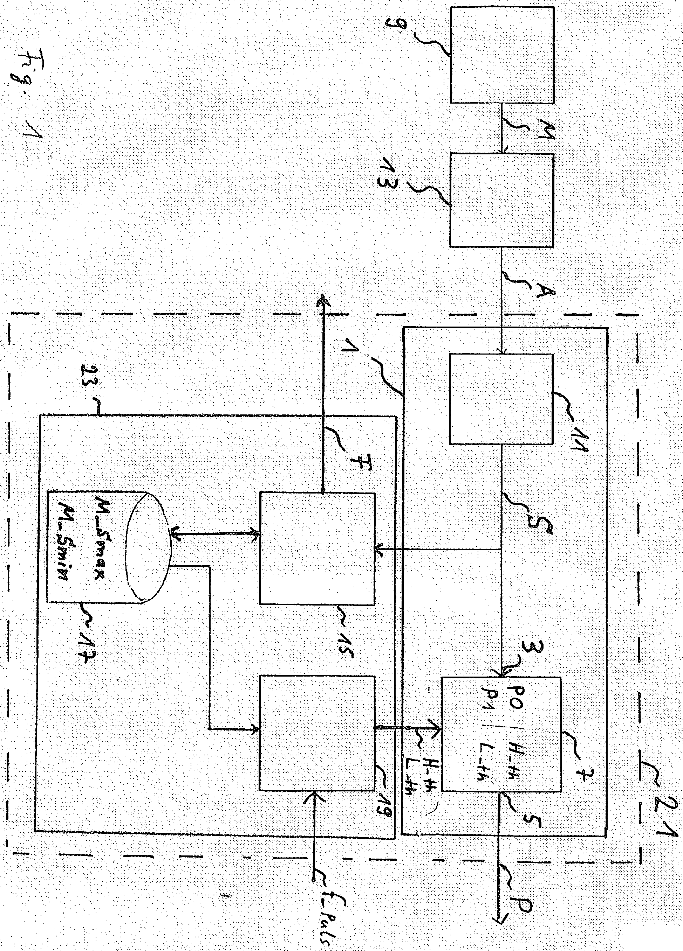

Ein Pulserkennungssystem 21 (Fig. 1) umfasst eine Pulserkennungsvorrichtung 1 und eine Vorrichtung 23 zum Betreiben der Pulserkennungsvorrichtung 1. Die Vorrichtung 23 zum Betreiben der Pulserkennungsvorrichtung 1 umfasst eine Vergleichereinheit 15, einen Datenspeicher 17 und eine Schwellenadaptionseinheit 19. Die Pulserkennungsvorrichtung 1 umfasst eine Entscheidervorrichtung 7 und einen Analog-Digital-Wandler 11. Die Entscheidervorrichtung 7 kann beispielsweise als Schmitt-Trigger ausgebildet sein. Die Vorrichtung 23 zum Betreiben der Pulserkennungsvorrichtung 1 ist beispielsweise als Recheneinheit mit Daten- und Programmspeicher ausgebildet. Auch die Pulserkennungsvorrichtung 1 kann Teil solch einer Recheneinheit mit Daten- und Programmspeicher, zum Beispiel eines Microcontrollers, sein. Die Vorrichtung 23 zum Betreiben der Pulserkennungsvorrichtung 1 kann auch getrennt ausgebildet sein mit separater Recheneinheit und separatem Speicher oder mit separaten Hardware-Schaltungskomponenten.

Ein analoges Pulssignal A wird beispielsweise mit einem der Pulserkennungsvorrichtung 1 zugeordneten Analog-Digital-Wandler 11 in digitale Signalwerte S gewandelt. Das analoge Pulssignal A repräsentiert beispielsweise ein Messsignal M eines Sensors 9. Der Sensor 9 kann beispielsweise als HallSensor ausgebildet sein. Der Sensor 9 ist beispielsweise ausgebildet, Drehbewegungen eines rotierenden Elements zu erfassen und in einem Getriebe angeordnet. Dem Sensor 9 ist eine Signalaufbereitungseinheit 13 zugeordnet, die beispielsweise ausgebildet ist, das Messsignal M zu verstärken und/oder zu filtern.

Der Analog-Digital-Wandler 11 ist gekoppelt mit einer Vergleichereinheit 15. Die digitalen Signalwerte S werden eingangsseitig der Vergleichereinheit 15 zugeführt. Die Vergleichereinheit 15 ist ausgebildet, jeweils für eine vorgegebene Segmentzeitdauer T aus den eingangsseitig empfangenen digitalen Signalwerten S eine erste Wertemenge M_Smax der größten digitalen Signalwerte S und eine zweite Wertemenge M_Smin der kleinsten digitalen Signalwerte S zu ermitteln. Beispielsweise ist die Vergleichereinheit 15 ausgebildet, ein Fehlersignal F auszugeben, wenn über eine vorgegebene Beobachtungszeitdauer T_check eine vorgegebene Fehleranzahl N_Fehler von digitalen Signalwerten S einen für das analoge Pulssignal A charakteristischen minimalen Amplitudenwert A_min unterschreiten oder einen für das analoge Pulssignal charakteristischen maximalen Amplitudenwert A_max überschreiten.

Der Vergleichereinheit 15 ist beispielsweise ein Datenspeicher 17 zugeordnet, der ausgebildet ist, die digitalen Signalwerte S der ersten Wertemenge M_Smax und der zweiten Wertenmenge M_Smin zu speichern. Zur Beginn einer erneuten Ermittlung der ersten Wertemenge M_Smax und zweiten Wertemenge M_Smin wird der Datenspeicher beispielsweise initialisiert.

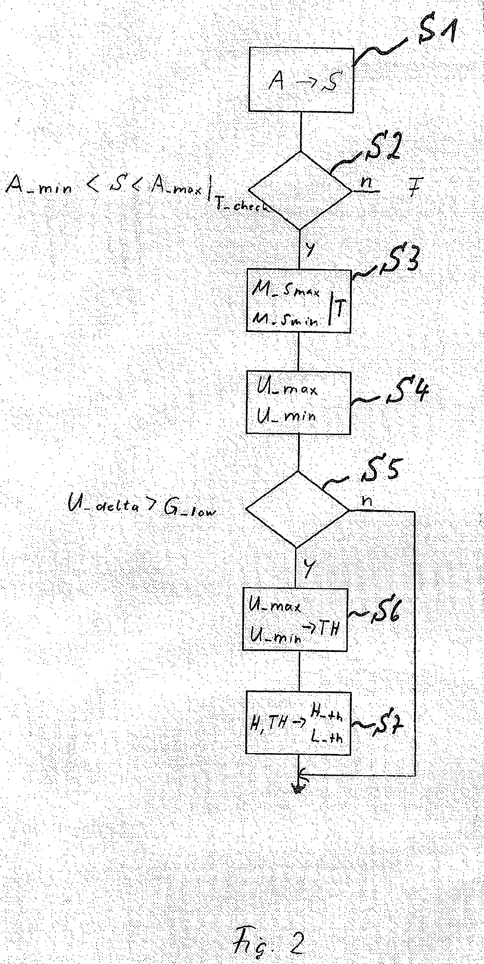

Die Schwellenadaptionseinheit 19 ist ausgebildet, einen ersten Schwellenwert H_th und/oder einen zweiten Schwellenwert L_th für die Entscheidervorrichtung 7 zu ermitteln und anzupassen, was weiter unten anhand des Ablaufdiagramms gemäß Figur 2 noch näher erläutert ist. Beispielsweise ist die Schwellenadaptionseinheit 19 ausgebildet aus den digitalen Signalwerten S der ersten Wertemenge M_Smax einen arithmetischen Maximalmittelwert U_max und aus den digitalen Signalwerten S der zweiten Wertemenge M_Smin ein arithmetischen Minimalmittelwert U_min zu bilden. Die Schwellwertadaptionseinheit 19 ist beispielsweise ausgebildet, eine Amplitudendynamik U_delta zu ermitteln abhängig von der Differenz des Maximalmittelwertes U_max und des Minimalmittelwertes U_min.

Die Schwellenadaptionseinheit 19 ist gekoppelt mit der Entscheidervorrichtung 7. Die Entscheidervorrichtung 7 ist ausgebildet, die digitalen Signalwerte S eingangsseitig zu empfangen und ausgangsseitig beispielsweise einen ersten Ausgangssignalwert P1 auszugeben, wenn der am Eingang 3 anliegende digitale Signalwert S größer ist als der vorgegebene erste Schwellenwert H_th und einen zweiten Ausgangssignalwert P0 ausgangsseitig auszugeben, wenn der am Eingang 3 anliegende digitale Signalwert S kleiner ist als der vorgegebene zweite Schwellenwert L_th, wobei der zweite Schwellenwert L_th kleiner ist als der erste Schwellenwert H_th.

Das Pulserkennungssystem 21 ist vorzugsweise als Digitalschaltung ausgebildet, vorzugsweise als Software auf einem Microcontroller oder in digitaler Hardware (ASIC, FPGA). Eine Realisierung mittels Microcontroller oder FPGA gestattet beispielsweise das Pulserkennungssystem 21 an zukünftige Anforderungen anzupassen ohne Änderungen an Hardware-Schaltungskomponenten vornehmen zu müssen. Im Vergleich zu einem manuellen Abgleich eines analogen Pulsgebers gestattet die Realisierung als Digitalschaltung unter definierten Randbedingungen eine automatische Kalibrierung.

Figur 2 zeigt ein Ablaufdiagramm eines Programms zum Betreiben einer Pulserkennungsvorrichtung 1. Das Programm ist in einem Programmspeicher gespeichert und wird während des Betriebs der Pulserkennungsvorrichtung 1 beispielsweise in der Recheneinheit abgearbeitet.

In einem Schritt S1 wird beispielsweise das analoge Pulsignal A mit einer Abtastfrequenz f_Sample abgetastet und in digitale Signalwerte S gewandelt.

In einem Schritt S2 kann vorgesehen sein, die digitalen Signalwerte S zu vergleichen mit einem für das analoge Pulssignal A charakteristischen minimalen Amplitudenwert A_min und einem maximalen Amplitudenwert A_max und ein Fehlersignal F auszugeben, wenn über eine vorgegebene Beobachtungszeitdauer T_check eine vorgegebene Fehleranzahl N_Fehler an digitalen Signalwerten S den für das analoge Pulssignal A charakteristischen minimalen Amplitudenwert A_min unterschreiten oder einen für das analoge Pulssignal charakteristischen maximalen Amplitudenwert A_max überschreiten.

In einem Schritt S3 werden beispielsweise für die vorgegebene Segmentzeitdauer T eine erste Kandidatenanzahl N_Kand_max von größten digitalen Signalwerten S und eine zweite Kandidatenanzahl N_Kand_min von kleinsten digitalen Signalwerten S ermittelt und jeweils eine erste Verwerfanzahl N_Reject_max der größten digitalen Signalwerte S verworfen und die verbleibenden größten digitalen Signalwerte S der ersten Wertenmenge M_Smax zugeordnet und eine zweite Verwerfanzahl N_Reject_min der kleinsten digitalen Signalwerte S verworfen und die verbleibenden kleinsten digitalen Signalwerte S der zweiten Wertenmenge M_Smin zugeordnet, wobei die erste Kandidatenanzahl N_Kand_max um die erste Verwerfanzahl N_Reject_max größer ist als die erste Anzahl N_Emax und die zweite Kandidatenanzahl N_Kand_min um die zweite Verwerfanzahl N_Reject_min größer ist als die zweite Anzahl N_Emin. Beispielsweise kann die erste Kandidatenanzahl N_Kand_max um eins größer gewählt werden als die erste Anzahl N_Emax und die zweiten Kandidatenanzahl N_Kand_min um eins größer gewählt werden als die erste Anzahl N_Emin und jeweils ein Wert von den ermittelten größten und kleinsten digitalen Signalwerte S, der beispielsweise stark verrauscht oder fehlerbehaftet ist, verworfen wird.

Die Segmentzeitdauer T kann beispielsweise in Abhängigkeit einer unteren Grenzfrequenz f_min des analogen Pulssignals A festgelegt werden, beispielsweise indem die Segmentzeitdauer T dem Kehrwert der unteren Grenzfrequenz f_min entspricht.

In einem Schritt S4 wird beispielsweise aus der ersten Wertemenge M_Smax ein arithmetischer Maximalmittelwert U_max und aus der zweiten Wertemenge M_Smin ein arithmetischer Minimalmittelwert U_min ermittelt.

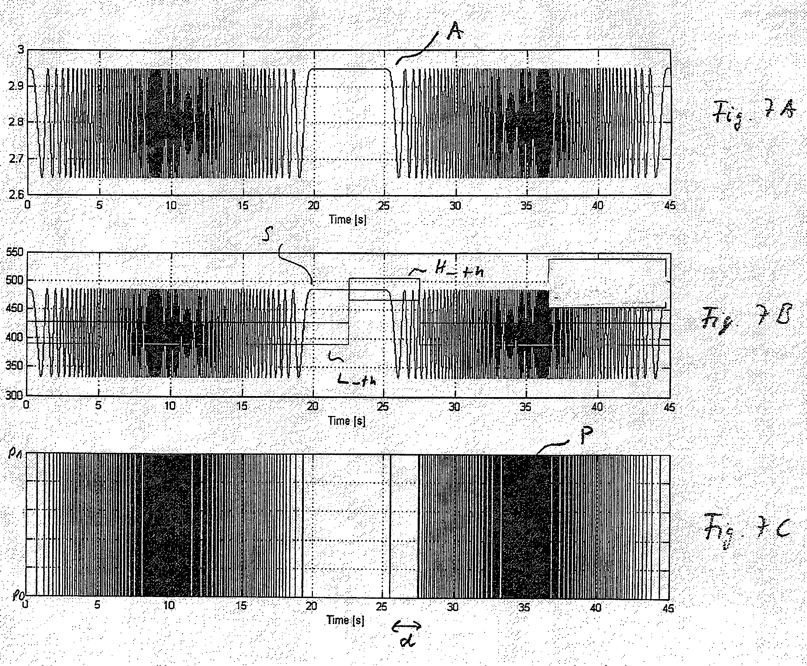

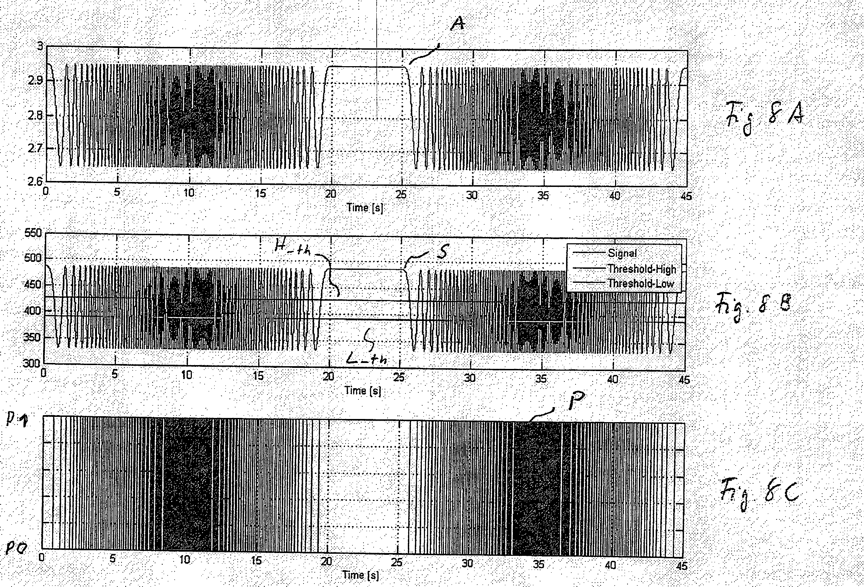

In einem Schritt S5 kann beispielsweise eine Amplitudendynamik U_delta ermittelt werden abhängig von der Differenz des Maximalmittelwertes U_max und des Minimalmittelwertes U_min. Ein Anpassen des ersten Schwellenwertes H_th und/oder des zweiten Schwellenwertes L_th wird ausgesetzt, wenn die Amplitudendynamik U_delta einen vorgegebenen unteren Grenzwert G_low unterschreitet. Der Vorteil dieses Vorgehens ist in Figur 7A-7C und Figur 8A-8C veranschaulicht.

In einem Schritt S6 wird beispielsweise der Entscheiderschwellwert TH in Abhängigkeit des Maximalmittelwertes U_max und des Minimalmittelwertes U_min ermittelt. Beispielsweise kann dem Entscheiderschwellwert TH ein arithmetischer Mittelwert, welcher aus dem Maximalmittelwert U max und dem Minimalmittelwert U_min gebildet wird, unter Berücksichtigung eines Proportionalitätsfaktors zugeordnet werden.

In einem Schritt S7 wird beispielsweise der erste Schwellenwert H_th und der zweite Schwellenwert L_th ermittelt abhängig von dem Entscheiderschwellwert TH und einem vorgegebenen Hysteresewert H, wobei der Hysteresewert fest vorgegeben sein kann oder auch während des Betriebes anpassbar sein kann. Der erste Schwellenwert H_th wird zum Beispiel ermittelt durch Addition des Entscheiderschwellwerts TH und des halben Hysteresewertes H und der zweite Schwellenwert L_th durch Subtrahieren des halben Hysteresewertes H von dem Entscheiderschwellwert TH.

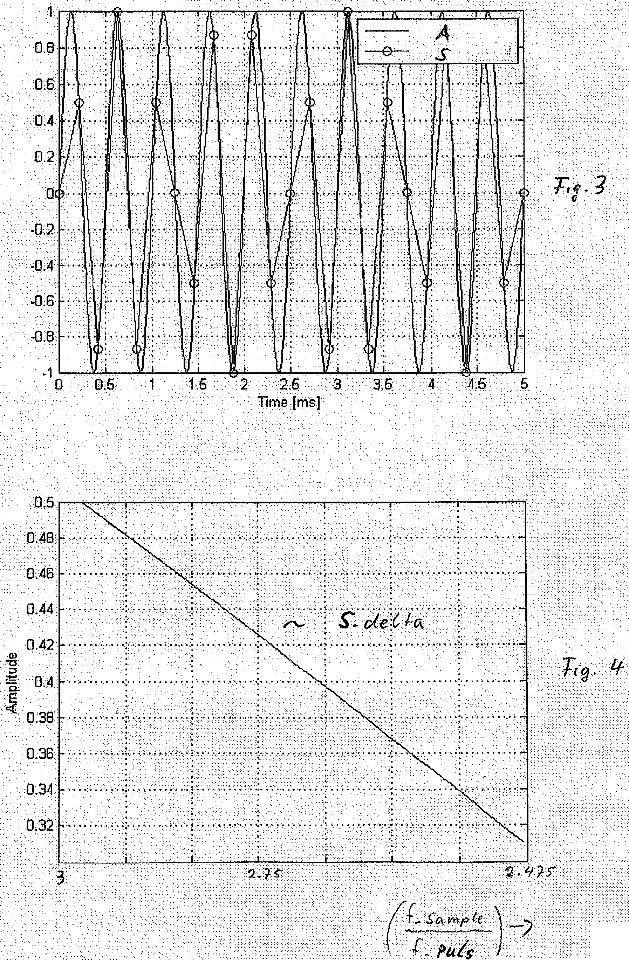

Figur 3 zeigt den Verlauf eines beispielhaften analogen Pulssignal A und einen diesem analogen Pulssignal A zugeordneten beispielhaften Verlauf der digitalen Signalwerte S. Dem analogen Pulssignal A kann eine Pulsfrequenz f_Puls und ein Scheitelwert S_top zugeordnet werden. Das analoge Pulssignal A wurde mit einer Abtastfrequenz f_Sample abgetastet, die geringfügig größer ist als die doppelte Pulsfrequenz f_Puls. Die einzelnen digitalen Signalwerte S sind mit Kreisen markiert. Je nach Phasenlage eines Abtastzeitpunktes innerhalb einer Schwingungsperiode weichen die einzelnen digitalen Signalwerte S von dem Scheitelwert S_top erheblich ab. Der Zusammenhang zwischen einer maximalen Abweichung S_delta der einzelnen digitalen Signalwerte S von dem Scheitelwert S_top in Abhängigkeit der analogen Pulsfrequenz f_Puls und der Abtastfrequenz f_Sample ist in Figur 4 dargestellt. Wenn die Abtastfrequenz f_Sample dreimal so groß ist wie die Pulsfrequenz f_Puls des analogen Pulssignals A entspricht die maximale Abweichung S_delta ungefähr 50%.

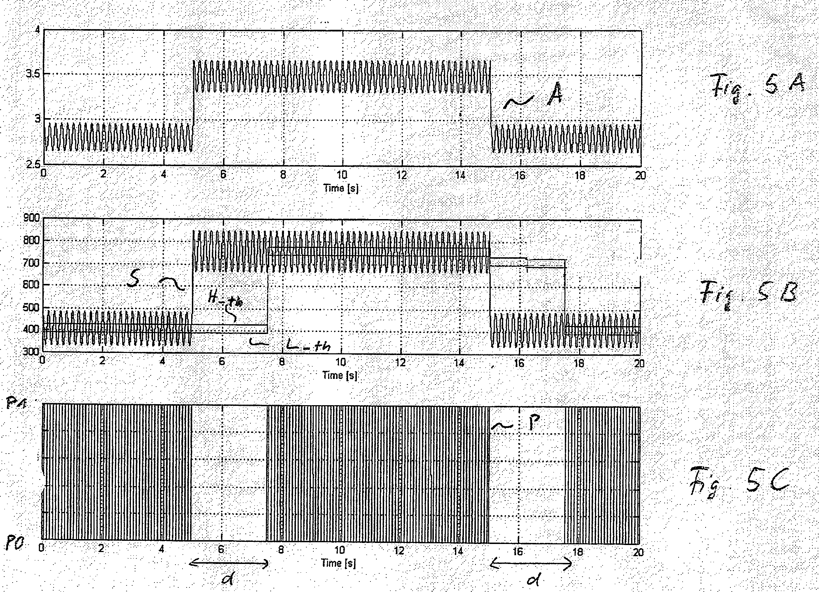

Figur 5A zeigt einen ersten Verlauf des analogen Pulssignals A. Das analoge Pulssignal A weist einen Gleichanteil auf, der sich zu verschiedenen Zeitpunkten sprunghaft ändert. In Figur 5B ist ein erster Verlauf der digitalen Signalwerte S und ein erster Verlauf des ersten Schwellenwerts H_th und des zweiten Schwellenwerts L_th, die jeweils dem ersten Verlauf des analogen Pulssignals A zugeordnet sind, dargestellt. Aus Gründen der Veranschaulichung ist der erste Verlauf der digitalen Signalwerte S interpoliert dargestellt. Es ist zu erkennen, dass die Anpassung des ersten H_th und zweiten Schwellenwerts L_th mit einer zeitlichen Verzögerung d erfolgt, die abhängig ist von der gewählten Segmentzeitdauer T. Die zeitliche Verzögerung d für die Anpassung des ersten H_th und des zweiten Schwellenwertes L_th führt dazu, dass Pulse des analogen Pulssignals A innerhalb der zeitlichen Verzögerung d nicht erkannt werden können. Das Beispiel zeigt, dass stationäre Verschiebungen des Gleichanteils kompensiert werden können und eine manipulative Arbeitspunktverschiebung des Sensors 9, beispielsweise durch Anbringen eines Permanentmagneten am Sensor 9, kompensiert werden kann.

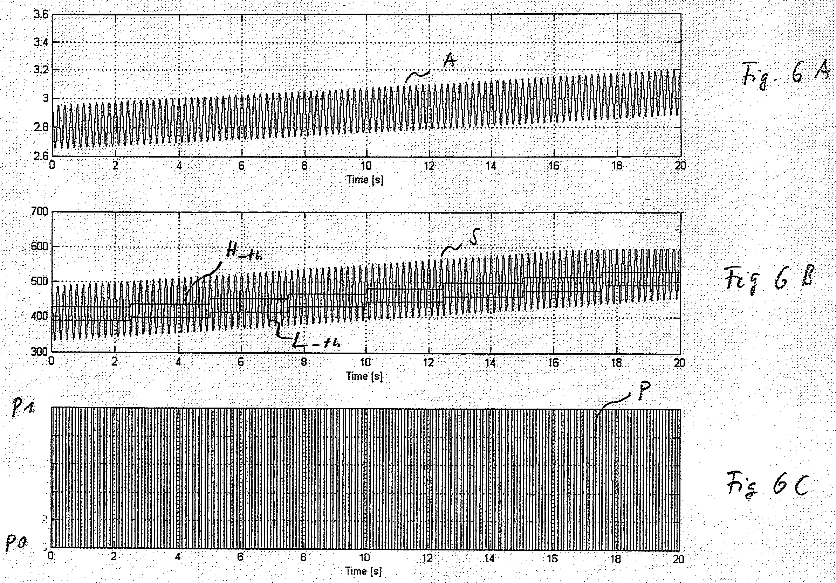

Figur 6A zeigt einen zweiten Verlauf des analogen Pulssignals A. Das analoge Pulssignal A weist einen kontinuierlich ansteigenden Gleichanteil auf. In Figur 6B ist ein zweiter Verlauf der digitalen Signalwerte S und ein zweiter Verlauf des ersten Schwellenwerts H_th und des zweiten Schwellenwerts L_th, die jeweils dem zweiten Verlauf des analogen Pulssignals A zugeordnet sind, dargestellt. Aus Gründen der Veranschaulichung ist der zweite Verlauf der digitalen Signalwerte S interpoliert dargestellt. Der erste H_th und zweite L_th Schwellenwert folgen dem kontinuierlich ansteigendem Gleichanteil mit der Verzögerung d, allerdings werden bei einer Gleichanteilsverschiebung mit geringem Gradienten, wie es in Figur 6B dargestellt ist, die Pulse des analogen Pulssignals A fortlaufend richtig erkannt.

Figur 7A zeigt einen dritten Verlauf des analogen Pulssignals A. Das analoge Pulssignal A ist über einen gewissen Zeitabschnitt quasi konstant. In Figur 7B ist ein dritter Verlauf der digitalen Signalwerte S und ein dritter Verlauf des ersten Schwellenwerts H_th und des zweiten Schwellenwerts L_th, die jeweils dem dritten Verlauf des analogen Pulssignals A zugeordnet sind, dargestellt. Aus Gründen der Veranschaulichung ist der dritte Verlauf der digitalen Signalwerte S interpoliert dargestellt. In diesem Fall wurde bei der Anpassung des ersten H_th und des zweiten Schwellenwertes L_th, die Anpassung des ersten H_th und des zweiten Schwellenwertes L_th nicht ausgesetzt, wenn die Amplitudendynamik U_delta einen vorgegebenen unteren Grenzwert G_low unterschreitet. Dem analogen Pulssignal A wird ein Gleichanteil zugeordnet und der erste H_th und zweite Schwellenwert L_th werden entsprechend dieses Gleichanteils angepasst. Sobald sich das analoge Pulssignal A zeitlich wieder schneller ändert, ergibt sich eine zeitliche Verzögerung d während der Pulse des analogen Pulssignals A nicht richtig erkannt werden.

Figur 8 korrespondiert zu Figur 7 mit dem Unterschied, dass bei der Anpassung des ersten H_th und des zweiten Schwellenwertes L_th, die Anpassung des ersten H_th und des zweiten Schwellenwertes L_th ausgesetzt wird, wenn die Amplitudendynamik U_delta einen vorgegebenen unteren Grenzwert G_low unterschreitet. Die Pulse des analogen Pulssignals werden kontinuierlich richtig erkannt.

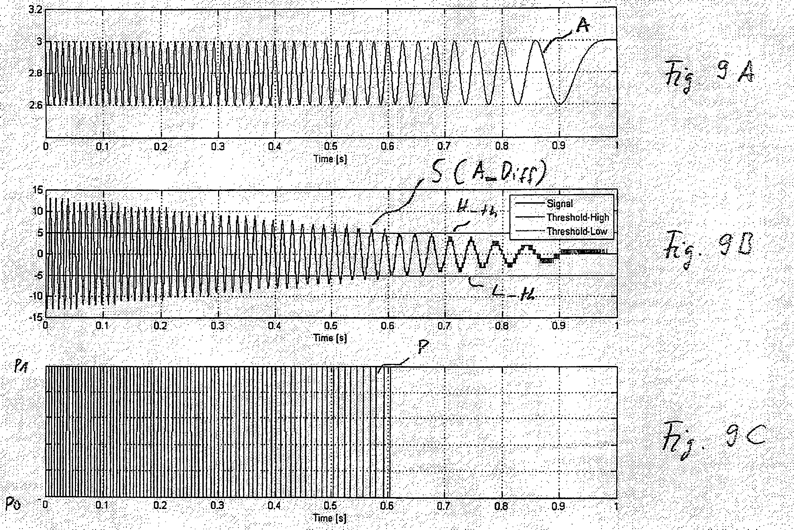

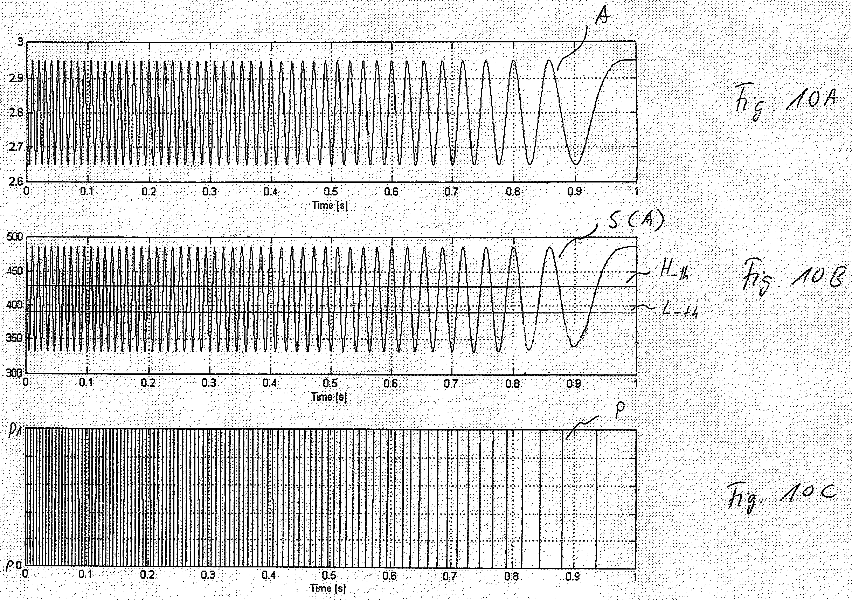

Bei der in Figur 1 gezeigten Anordnung wird beispielsweise das analoge Pulssignale A unmittelbar in digitale Signalwerte S, die eingangsseitig an der Entscheidervorrichtung 7 anliege, gewandelt. Im Gegensatz zu den offenbarten Ausgestaltungen der Erfindung hat ein Auswerten eines differentiellen Signals A_Diff, welches näherungsweise eine zeitliche Ableitung des analogen Pulssignals A repräsentiert, den Nachteil, dass die digitalen Signalwerte S für analoge Pulssignale A mit geringen Pulsfrequenzen f_Puls die digitalen Signalwerte S nur noch einen kleinen Wertebereich einnehmen und die digitalen Signalwerte S nicht korrekt ausgewertet werden. Figur 9A zeigt einen fünften Verlauf des analogen Pulssignals A. In Figur 9B ist ein fünfter Verlauf der digitalen Signalwerte S und ein fünfter Verlauf des ersten Schwellenwerts H_th und des zweiten Schwellenwerts L_th dargestellt, die einem differentiellen Signal A_Diff zugeordnet sind, welches aus dem fünften Verlauf des analogen Pulssignals A abgeleitet wurde. In Figur 10B wird im Vergleich zu Figur 9B das analoge Pulssignal A ausgewertet.

## Patentansprüche

1. Verfahren zum Betreiben einer Pulserkennungsvorrichtung (1), die eine Entscheidervorrichtung (7) umfasst mit einem Eingang (3) und einem Ausgang (5), wobei die Entscheidervorrichtung (7) ausgebildet ist,
- digitale Signalwerte (S), welche ein digital gewandeltes Pulssignal eines analogen Pulssignals (A) repräsentieren, eingangsseitig zu empfangen
- und einen ersten Ausgangssignalwert (P1) ausgangsseitig auszugeben, wenn der am Eingang (3) anliegende digitale Signalwert (S) größer ist als ein vorgegebener erster Schwellenwert (H_th) und einen zweiten Ausgangssignalwert (P0) ausgangsseitig auszugeben, wenn der am Eingang (3) anliegende digitale Signalwert (S) kleiner ist als ein vorgegebener zweiter Schwellenwert (L_th), der kleiner ist als der erste Schwellenwert (H_th),
und das Verfahren **dadurch gekennzeichnet ist, dass** es folgende Schritte umfasst:
- jeweils für eine vorgegebene Segmentzeitdauer (T) wird aus den eingangsseitig empfangenen digitalen Signalwerten (S) eine erste Wertemenge (M_Smax) mit einer vorgegebenen ersten Anzahl (N_Emax) der größten digitalen Signalwerte (S) ermittelt und eine zweite Wertemenge (M_Smin) mit einer vorgegebenen zweiten Anzahl (N_Emin) der kleinsten digitalen Signalwerte (S) ermittelt und
- der erste Schwellenwert (H_th) wird angepasst abhängig von der ersten Wertemenge (M_Smax) und/oder der zweite Schwellenwert (L_th) wird angepasst abhängig von der zweiten Wertemenge (M_Smin), wobei der erste Schwellenwert (H_th) und der zweite Schwellenwert (L_th) ermittelt wird abhängig von einem Entscheiderschwellwert (TH) und einem vorgegebenen Hysteresewert (H) und der Entscheiderschwellwert (TH) ermittelt wird abhängig von den digitalen Signalwerten (S) der ersten Wertemenge (M_Smax) und der zweiten Wertemenge (M_Smin) und der Hysteresewert (H) angepasst wird in Abhängigkeit einer für das analoge Pulssignal (A) ermittelten Frequenz.

2. Verfahren nach Anspruch 1, wobei aus den digitalen Signalwerten (S) der ersten Wertemenge (M_Smax) ein arithmetischer Maximalmittelwert (U_max) und aus den digitalen Signalwerten (S) der zweiten Wertemenge (M_Smin) ein arithmetischer Minimalmittelwert (U_min) gebildet wird und der erste Schwellenwert (H_th) und/oder der zweite Schwellenwert (L_th) abhängig von dem Maximalmittelwert (U_max) und Minimalmittelwert (U_min) angepasst wird.

3. Verfahren nach einem der vorstehenden Ansprüche, wobei die erste Anzahl (N_Emax) und die zweite Anzahl (N_Emin) einer Zweierpotenz entsprechen.

4. Verfahren nach einem der vorstehenden Ansprüche, wobei die erste Anzahl (N_Emax) und die zweite Anzahl (N_Emin) gleich groß sind.

5. Verfahren nach einem der vorstehenden Ansprüche, wobei jeweils über die Segmentzeitdauer (T) eine erste Kandidatenanzahl (N_Kand_max) von größten digitalen Signalwerten (S) und eine zweite Kandidatenanzahl (N_Kand_min) von kleinsten digitalen Signalwerten (S) ermittelt werden und jeweils eine erste Verwerfanzahl (N_Reject_max) der größten digitalen Signalwerte (S) verworfen werden und die verbleibenden größten digitalen Signalwerte (S) der ersten Wertemenge (M_Smax) zugeordnet werden und eine zweite Verwerfanzahl (N_Reject_min) der kleinsten digitalen Signalwerte (S) verworfen werden und die verbleibenden kleinsten digitalen Signalwerte (S) der zweiten Wertemenge (M_Smin) zugeordnet werden und die erste Kandidatenanzahl (N_Kand_max) um die erste Verwerfanzahl (N_Reject_max) größer ist als die erste Anzahl (N_Emax) und die zweite Kandidatenanzahl (N_Kand_min) um die zweite Verwerfanzahl (N_Reject_min) größer ist als die zweite Anzahl (N_Emin).

6. Verfahren nach einem der vorstehenden Ansprüche, wobei die erste Wertemenge (M_Smax) und die zweite Wertemenge (M_Smin) erneut ermittelt werden jeweils für aufeinander folgende überlappende Segmentzeitdauern (T).

7. Verfahren nach einem der vorstehenden Ansprüche, wobei eine Amplitudendynamik (U_delta) ermittelt wird abhängig von der Differenz des Maximalmittelwertes (U_max) und des Minimalmittelwertes (U_min) und das Anpassen des ersten Schwellenwertes (H_th) und/oder des zweiten Schwellenwertes (L_th) ausgesetzt wird, wenn die Amplitudendynamik (U_delta) einen vorgegebenen unteren Grenzwert (G_low) unterschreitet.

8. Verfahren nach einem der vorstehenden Ansprüche, wobei ein Fehlersignal (F) ausgegeben wird, wenn über eine vorgegebene Beobachtungszeitdauer (T_check) eine vorgegebene Fehleranzahl (N_Fehler) an digitalen Signalwerten (S) einen für das analoge Pulssignal (A) charakteristischen minimalen Amplitudenwert (A_min) unterschreiten oder einen für das analoge Pulssignal (A) charakteristischen maximalen Amplitudenwert (A_max) überschreiten.

9. Verfahren nach einem der vorstehenden Ansprüche, wobei das analoge Pulssignal (A) ein Messsignal eines Sensors (9) repräsentiert.

10. Verfahren nach Anspruch 9, wobei der Sensor (9) ein Hallsensor ist.

11. Vorrichtung zum Betreiben einer Pulserkennungsvorrichtung (1), die eine Entscheidervorrichtung (7) umfasst mit einem Eingang (3) und einem Ausgang (5), wobei die Entscheidervorrichtung (7) ausgebildet ist,
- digitale Signalwerte (S), welche ein digital gewandeltes Pulssignal eines analogen Pulssignals (A) repräsentieren, eingangsseitig zu empfangen
- und einen ersten Ausgangssignalwert (P1) ausgangsseitig auszugeben, wenn der am Eingang (3) anliegende digitale Signalwert (S) größer ist als ein vorgegebener erster Schwellenwert (H_th) und einen zweiten Ausgangssignalwert (P0) ausgangsseitig auszugeben, wenn der am Eingang (3) anliegende digitale Signalwert (S) kleiner ist als ein vorgegebener zweiter Schwellenwert (L_th), der kleiner ist als der erste Schwellenwert (H_th),
und die Vorrichtung **dadurch gekennzeichnet ist, dass** sie dazu ausgebildet ist,
- jeweils für eine vorgegebene Segmentzeitdauer (T) aus den eingangsseitig empfangenen digitalen Signalwerten (S) eine erste Wertemenge (M_Smax) mit einer vorgegebenen ersten Anzahl(N_Emax) der größten digitalen Signalwerte (S) zu ermitteln und eine zweite Wertemenge (M_Smin) mit einer vorgegebenen zweiten Anzahl (N_Emin) der kleinsten digitalen Signalwerte (S) zu ermitteln und
- den ersten Schwellenwert (H_th) anzupassen abhängig von der ersten Wertemenge (M_Smax) und/oder den zweiten Schwellenwert (L_th) anzupassen abhängig von der zweiten Wertemenge (M_Smin), wobei der erste Schwellenwert (H_th) und der zweite Schwellenwert (L_th) ermittelt wird abhängig von einem Entscheiderschwellwert (TH) und einem vorgegebenen Hysteresewert (H) und der Entscheiderschwellwert (TH) ermittelt wird abhängig von den digitalen Signalwerten (S) der ersten Wertemenge (M_Smax) und der zweiten Wertemenge (M_Smin) und der Hysteresewert (H) angepasst wird in Abhängigkeit einer für das analoge Pulssignal (A) ermittelten Frequenz.

## Claims

1. Method for the operation of a pulse detection device (1) that comprises a decision device (7) with an input (3) and an output (5), wherein the decision device (7) is designed,
- to receive at its input digital signal values (S) that represent a digitally converted pulse signal of an analog pulse signal (A)
- and to output a first output signal value (P1) at its output when the digital signal value (S) present at the input (3) is larger than a predetermined first threshold value (H_th), and to ouput a second output signal value (P0) at its output when the digital digitalsignal value (S) present at the input (3) is smaller than a predetermined second threshold value (L_th) which is smaller than the first threshold value (H_th)
and the method is **characterized in that** it comprises the following steps:
- during a predetermined segment time period (T) in each case, a first set of values (M_Smax) with a predetermined first number (N_Emax) of the largest digital signal values (S) and a second set of values (M_Smin) with a predetermined second number (N_Emin) of the smallest digital signal values (S) are determined from the digital signal values (S) received at the input, and
- the first threshold value (H_th) is adjusted depending on the first set of values (M_Smax) and/or the second threshold value (L_th) is adjusted depending on the second set of values (M_Smin), wherein the first threshold value (H_th) and the second threshold value (L_th) are determined depending on a decision threshold value (TH) and on a predetermined hysteresis value (H), and the decision threshold value (TH) is determined depending on the digital signal values (S) of the first set of values (M_Smax) and of the second set of values (M_Smin), and the hysteresis value (H) is adjusted depending on a frequency determined for the analog pulse signal (A).

2. Method according to Claim 1, wherein an arithmetic maximum mean value (U_max) is formed from the digital signal values (S) of the first set of values (M_Smax) and an arithmetic minimum mean value (U_min) is formed from the digital signal values (S) of the second set of values (M_Smin), and the first threshold value (H_th) and/or the second threshold value (L_th) is adjusted depending on the maximum mean value (U_max) and the minimum mean value (U_min).

3. Method according to one of the previous claims, wherein the first number (N_Emax) and the second number (N_Emin) correspond to a power of two.

4. Method according to one of the previous claims, wherein the first number (N_Emax) and the second number (N_Emin) have the same size.

5. Method according to one of the previous claims, wherein respectively for the segment time period (T) a first candidate number (N_Kand_max) of largest digital signal values (S) and a second candidate number (N_Kand_min) of smallest digital signal values (S) are determined, and respectively a first reject number (N_Reject_max) of the largest digital signal values (S) are rejected and the remaining largest digital signal values (S) are assigned to the first set of values (M_Smax), and a second reject number (N_Reject_min) of the smallest digital signal values (S) are rejected and the remaining smallest digital signal values (S) are assigned to the second set of values (M_Smin), wherein the first candidate number (N_Kand_max) is larger than the first number (N_Emax) by the first reject number (N_Reject_max), and the the second candidate number (N_Kand_min) is larger than the second number (N_Emin) by the second reject number (N_Reject_min).

6. Method according to one of the previous claims, wherein the first set of values (M_Smax) and the second set of values (M_Smin) are each determined again for sequential, overlapping segment time periods (T).

7. Method according to one of the previous claims, wherein an amplitude dynamic (U_delta) is determined depending on the difference between the maximum mean value (U_max) and the minimum mean value (U_min), and the adjustment of the first threshold value (H_th) and/or of the second threshold value (L_th) is suspended if the amplitude dynamic (U_delta) is below a predetermined lower limit value (G_low).

8. Method according to one of the previous claims, wherein an error signal (F) is output if, over a predetermined observation time period (T_check), a predetermined number of errors (N_Fehler) in the digital signal values (S) falls below a minimum amplitude value (A_min) characteristic for the analog pulse signal (A), or exceeds a maximum amplitude value (A_max) characteristic for the analog pulse signal.

9. Method according to one of the previous claims, wherein the analog pulse signal (A) represents a measurement signal of a sensor (9).

10. Method according to Claim 9, wherein the sensor (9) is a Hall sensor.

11. Device for the operation of a pulse detection device (1) that comprises a decision device (7) with an input (3) and an output (5), wherein the decision device (7) is designed,
- to receive at its input digital signal values (S) that represent a digitally converted pulse signal of an analog pulse signal (A)
- and to output a first output signal value (P1) at its output when a digital signal value (S) present at the input (3) is larger than a predetermined first threshold value (H_th) and to output a second output signal value (P0) at its output when the digital signal value (S) present at the input (3) is smaller than a predetermined second threshold value (L_th) which is smaller than the first threshold value (H_th) and the device is **characterized in that** it is designed
- during a predetermined segment time period (T) in each case, to determine from the digital signal values (S) received at the input a first set of values (M_Smax) with a predetermined first number (N_Emax) of the largest digital signal values (S) and a second set of values (M_Smin) with a predetermined second number (N_Emin) of the smallest digital signal values (S), and
- to adjust the first threshold value (H_th) depending on the first set of values (M_Smax) and/or to adjust the second threshold value (L_th) depending on the second set of values (M_Smin), wherein the first threshold value (H_th) and the second threshold value (L_th) are determined depending on a decision threshold value (TH) and on a predetermined hysteresis value (H), and the decision threshold value (TH) is determined depending on the digital signal values (S) of the first set of values (M_Smax) and of the second set of values (M_Smin), and the hysteresis value (H) is adjusted depending on a frequency determined for the analog pulse signal (A).

## Revendications

1. Procédé de mise en fonctionnement d'un dispositif de détection d'impulsions (1), comprenant un dispositif de décision (7) comportant une entrée (3) et une sortie (5), dans lequel le dispositif décideur (7) est conçu pour
- recevoir en entrée des valeurs de signaux numériques (S) qui représentent un signal impulsionnel numérique converti d'un signal impulsionnel analogique (A),
- et délivrer en sortie une première valeur de signal de sortie (P1) lorsque la valeur de signal numérique (S) présente à l'entrée (3) est supérieure à une première valeur de seuil prédéterminée (H_th) et pour délivrer en sortie une seconde valeur de signal de sortie (P0) lorsque la valeur de signal numérique (S) présente à l'entrée (3) est inférieure à une seconde valeur de seuil prédéterminée (L_th) qui est inférieure à la première valeur de seuil (H_th),
- et le procédé est **caractérisé en ce qu'**il comprend les étapes consistant à :
- déterminer respectivement, pendant un intervalle de temps de segment prédéterminé (T), à partir des valeurs de signaux numériques (S) reçues en entrée, une première quantité de valeurs (M_Smax) comportant un premier nombre prédéterminé (N_Emax) de valeurs de signaux numériques (S) les plus grandes et déterminer une seconde quantité de valeurs (M_Smin) comportant un second nombre prédéterminé (N_Emin) des valeurs de signaux numériques (S) les plus petites, et
- adapter la première valeur de seuil (H_th) en fonction de la première quantité de valeurs (M_Smax) et/ou adapter la seconde valeur de seuil (L_th) en fonction de la seconde quantité de valeurs (M_Smin), dans lequel la première valeur de seuil (H_th) et la seconde valeur de seuil (L_th) sont déterminées en fonction d'une valeur de seuil de décision (TH) et d'une valeur d'hystérésis (H) prédéterminée et la valeur de seuil de décision (TH) est déterminée en fonction des valeurs de signaux numériques (S) de la première quantité de valeurs (M_Smax) et de la seconde quantité de valeurs (M_Smin) et la valeur d'hystérésis (H) est adaptée en fonction d'une fréquence déterminée pour le signal impulsionnel analogique (A).

2. Procédé selon la revendication 1, dans lequel une valeur moyenne arithmétique maximale (U_max) est établie à partir des valeurs de signaux numériques (S) de la première quantité de valeurs (M_Smax) et une valeur moyenne arithmétique minimale (U_min) est établie à partir des valeurs de signaux numériques (S) de la seconde quantité de valeurs (M_Smin) et la première valeur de seuil (H_th) et/ou la seconde valeur de seuil (L_th) sont adaptées en fonction de la valeur moyenne maximale (U_max) et de la valeur moyenne minimale (U_min).

3. Procédé selon l'une quelconque des revendications précédentes, dans lequel le premier nombre (N_Emax) et le second nombre (N_Emin) correspondent à une puissance de deux.

4. Procédé selon l'une quelconque des revendications précédentes, dans lequel le premier nombre (N_Emax) et le second nombre (N_Emin) présentent la même valeur.

5. Procédé selon l'une quelconque des revendications précédentes, dans lequel on détermine respectivement un premier nombre candidat (N_Kand_max) de valeurs de signaux numériques (S) les plus grandes au cours de l'intervalle de temps de segment (T) et un second nombre candidat (N_Kand_min) de valeurs de signaux numériques (S) les plus petites et on rejette respectivement un premier nombre de rejet (N_Reject_max) de valeurs de signaux numériques (S) les plus grandes, et on associe les valeurs de signaux numériques (S) les plus grandes restantes à la première quantité de valeurs (M_Smax) et on rejette un second nombre de rejet (N_Reject_min) de valeurs de signaux numériques (S) les plus petites, et on associe les valeurs de signaux numériques (S) les plus petites restantes à la seconde quantité de valeurs (M_Smin) et le premier nombre candidat (N_Kand_max) est supérieur d'une quantité égale au premier nombre de rejet (N_Reject_max) au premier nombre (N_Emax) et le second nombre candidat (N_Kand_min) est supérieur d'une quantité égale au second nombre de rejet (N_Reject_min) au deuxième nombre (N_Emin).

6. Procédé selon l'une quelconque des revendications précédentes, dans lequel la première quantité de valeurs (M_Smax) et la seconde quantité de valeurs (M_Smin) sont de nouveau respectivement déterminées pendant des intervalles de temps de segments (T) consécutifs se chevauchant.

7. Procédé selon l'une quelconque des revendications précédentes, dans lequel une dynamique d'amplitude (U_delta) est déterminée en fonction de la différence entre la valeur moyenne maximale (U_max) et la valeur moyenne minimale (U_min) et l'adaptation de la première valeur de seuil (H_th) et/ou de la seconde valeur de seuil (L_th) est suspendue lorsque la dynamique d'amplitude (U_delta) s'abaisse en dessous d'un valeur limite inférieure prédéterminée (G_low).

8. Procédé selon l'une quelconque des revendications précédentes, dans lequel un signal d'erreur (F) est délivré lorsqu'un nombre d'erreurs prédéterminé (N_Fehler) de valeurs de signaux numériques (S) s'abaisse pendant un intervalle de temps d'observation prédéterminé (T_check) en dessous d'une valeur d'amplitude minimale caractéristique (A_min) pour le signal impulsionnel analogique (A) ou s'élève au-dessus d'une valeur d'amplitude maximale caractéristique (A_max) pour le signal impulsionnel analogique (A).

9. Procédé selon l'une quelconque des revendications précédentes, dans lequel le signal impulsionnel analogique (A) représente un signal de mesure d'un capteur (9).

10. Procédé selon la revendication 9, dans lequel le capteur (9) est un capteur Hall.

11. Dispositif de mise en fonctionnement d'un dispositif de détection d'impulsions (1) comprenant un dispositif de décision (7) ayant une entrée (3) et une sortie (5), dans lequel le dispositif de décision (7) est conçu pour
- recevoir en entrée des valeurs de signaux numériques (S) qui représentent un signal impulsionnel numérique converti d'un signal impulsionnel analogique (A),
- et délivrer en sortie une première valeur de signal de sortie (P1) lorsque la valeur de signal numérique (S) présente à l'entrée (3) est supérieure à une première valeur de seuil prédéterminée (H_th) et pour délivrer en sortie une seconde valeur de signal de sortie (P0) lorsque la valeur de signal numérique (S) présente à l'entrée (3) est inférieure à une seconde valeur de seuil prédéterminée (L_th) qui est inférieure à la première valeur de seuil (H_th),
et le dispositif est **caractérisé en ce qu'**il est conçu pour :
- déterminer respectivement, pendant un intervalle de temps de segment prédéterminé (T), à partir des valeurs de signaux numériques (S) reçues en entrée, une première quantité de valeurs (M_Smax) comportant un premier nombre prédéterminé (N_Emax) des valeurs de signaux numériques (S) les plus grandes et pour déterminer une seconde quantité de valeurs (M_Smin) comportant un second nombre prédéterminé (N_Emin) de valeurs de signaux numériques (S) les plus petites, et
- adapter la première valeur de seuil (H_th) en fonction de la première quantité de valeurs (M_Smax) et/ou de la seconde valeur de seuil (L_th) en fonction de la seconde quantité de valeurs (M_Smin), dans lequel la première valeur de seuil (H_th) et la seconde valeur de seuil (L_th) sont déterminées en fonction d'une valeur de seuil de décision (TH) et d'une valeur d'hystérésis (H) prédéterminée et la valeur de seuil de décision (TH) est déterminée en fonction des valeurs de signaux numériques (S) de la première quantité de valeurs (M_Smax) et de la seconde quantité de valeurs (M_Smin) et la valeur d'hystérésis (H) est adaptée en fonction d'une fréquence déterminée pour le signal impulsionnel analogique (A).
